# EUROPEAN PATENT APPLICATION

(11) **EP 3 043 446 A1**
(43) Date of publication of application: **13.07.2016**
(21) Application number: 14841771.0
(22) Date of filing: 26.08.2014
(51) Int. Cl.: H02J 7/35, H02J 3/00, H02J 3/32, H02J 7/00

(54) **DISCHARGE START TIME DETERMINATION SYSTEM FOR ELECTRICITY STORAGE DEVICE AND DISCHARGE START TIME DETERMINATION METHOD FOR ELECTRICITY STORAGE DEVICE**

(30) Priority: 06.09.2013 JP 2013185387
(71) Applicant: Sekisui Chemical Co., Ltd., Osaka-shi, Osaka 530-8565 (JP)
(72) Inventor: TANAKA, Yuya, Tsukuba-shi Ibaraki 300-4292 (JP)
(74) Representative: Merkle, Gebhard
(86) International application number: PCT/JP2014/072285
(87) International publication number: WO 2015/033819

(57) **Abstract**

A discharge start time determination system for a storage battery (2) includes: an estimator (61) that estimates a power generation amount of a solar cell panel (1) and a power consumption amount; a power price database (53) in which the times at which the power price is changed are stored; a first comparator (621) that compares a necessary amount at a high price time with a dischargeable capacity; and a discharge start time determiner (63) that, when the necessary amount at the high price time is estimated to be the dischargeable capacity or more, sets a second time as a discharge start time, and that, when the necessary amount at the high price time is estimated to be less than the dischargeable capacity, sets any time equal to or later than a first time and earlier than the second time as the discharge start time.

## Description

### TECHNICAL FIELD

The present invention relates to a discharge start time determination system for an electricity storage device and a discharge start time determination method for an electricity storage device that are for effectively utilizing the electricity storage device in a building including a solar power generator and the electricity storage device.

### BACKGROUND ART

There is known charging and discharging control of an electricity storage device that is aimed at reducing electric power charge and leveling electric power load for a home including a solar power generator and an electricity storage device (refer to Patent Literatures 1-4, etc.).

For example, a storage battery charging and discharging apparatus of Patent Literature 1 includes a calculation unit for calculating an optimum charging and discharging schedule of a storage battery based on a constraint condition, and an extraction unit for extracting a similar charging and discharging schedule from past charging and discharging patterns. In addition, the storage battery charging and discharging apparatus is configured to display, on a display unit, a plurality of charging and discharging schedules calculated by the calculation unit and the extraction unit. A resident can be thereby provided with options.

In addition, Patent Literature 2 discloses a system that can reduce peak power demand using a small storage battery. In Patent Literature 2, the system is configured to reduce peak power demand by using power generation by a solar power generator in combination with power discharge from a storage battery in a daylight time zone in which power demand is at peak.

Furthermore, Patent Literatures 3 and 4 disclose a power control system that conducts a plurality of simulations with various discharge start times of an electricity storage device using past measurement data, and selects, from calculation results, a control pattern being optimum when evaluation is made for a relatively long time period.

### CITATION LIST

### Patent Literature

Patent Literature 1: JP 2010-268602 A
Patent Literature 2: JP 2003-79054 A
Patent Literature 3: JP 4967052 B1
Patent Literature 4: JP 5232266 B1

### SUMMARY

### Technical Problem

Nevertheless, the storage battery charging and discharging apparatus of Patent Literature 1 involves high calculation load because the apparatus not only simulates an optimum charging and discharging schedule, but also performs processing for extracting a similar pattern from past charging and discharging schedules. In addition, although a plurality of options of charging and discharging schedules is provided, a user needs to determine which of them to select.

In addition, the system disclosed in Patent Literature 2 can reduce peak power demand using a storage battery of small capacity, but the system is not configured to effectively utilize a storage battery of large capacity even if such a storage battery is installed.

In view of the foregoing, an object of the present invention is to provide a discharge start time determination system for an electricity storage device and a discharge start time determination method for an electricity storage device that can achieve effective utilization of the electricity storage device with less calculation load.

### Solution to Problem

In order to achieve the above object, according to the present invention, there is provided a discharge start time determination system for an electricity storage device in a building including a solar power generator and an electricity storage device, the discharge start time determination system including: an estimator that estimates a power generation amount of the solar power generator and a power consumption amount of the building; a power price memory that stores times at which price zones having different power prices are changed, the price zones including a mid-price zone starting from a first time and ending before a second time, a high price zone starting from the second time and ending before a third time, and a low price zone starting from the third time and ending before the first time of a following day; a first comparator that compares a necessary amount at a high price time that is obtained by subtracting the power generation amount from the power consumption amount in the high price zone, with a dischargeable capacity of the electricity storage device; and a discharge start time determiner that, when the necessary amount at the high price time is estimated by the first comparator to be the dischargeable capacity or more, sets the second time as a discharge start time, and that, when the necessary amount at the high price time is estimated to be less than the dischargeable capacity, sets any time that is equal to or later than the first time and earlier than the second time as a discharge start time.

Further, there is provided a discharge start time determination method for an electricity storage device in a building including a solar power generator and an electricity storage device, when a mid-price zone starting from a first time and ending before a second time, a high price zone starting from the second time and ending before a third time, and a low price zone starting from the third time and ending before the first time of a following day are different in power price, the discharge start time determination method including: an estimation step of estimating a power generation amount of the solar power generator and a power consumption amount of the building; a first comparison step of comparing a necessary amount at a high price time that is obtained by subtracting the power generation amount from the power consumption amount in the high price zone, with a dischargeable capacity of the electricity storage device; and a discharge start time determination step of, when the necessary amount at the high price time is estimated in the first comparison step to be the dischargeable capacity or more, setting the second time as a discharge start time, and of, when the necessary amount at the high price time is estimated to be less than the dischargeable capacity, setting any time that is equal to or later than the first time and earlier than the second time as a discharge start time.

### Advantageous Effects

The discharge start time determination system for the electricity storage device and the discharge start time determination method for the electricity storage device that have the above configurations compare a necessary amount at a high price time in a time zone with a high power price, which has been calculated by subtraction processing, with a dischargeable capacity of the electricity storage device, and bring a discharge start time forward if the dischargeable capacity has a surplus.

Thus, effective utilization of fully utilizing a dischargeable capacity of the electricity storage device can be achieved with less calculation load, i.e., subtraction.

### BRIEF DESCRIPTION OF DRAWINGS

[FIG. 1] FIG. 1 is an explanatory diagram illustrating a processing flow of a discharge start time determination system for a storage battery according to an embodiment of the present invention.
[FIG. 2] FIG. 2 is an explanatory diagram illustrating an example of a fee structure in which three or more different power prices are set.
[FIG. 3] FIG. 3 is an explanatory diagram schematically illustrating a configuration of an entire system.
[FIG. 4] FIG. 4 is a block diagram illustrating a configuration of a discharge start time determination system for a storage battery according to an embodiment of the present invention.
[FIG. 5] FIG. 5 is a flowchart illustrating a processing flow of an entire system including a discharge start time determination system.
[FIG. 6] FIG. 6 illustrates a list showing an example of an estimation result obtained by an estimator.
[FIG. 7] FIG. 7 is an explanatory diagram illustrating a display example of a determination result obtained by a discharge start time determiner.

### DESCRIPTION OF EMBODIMENT

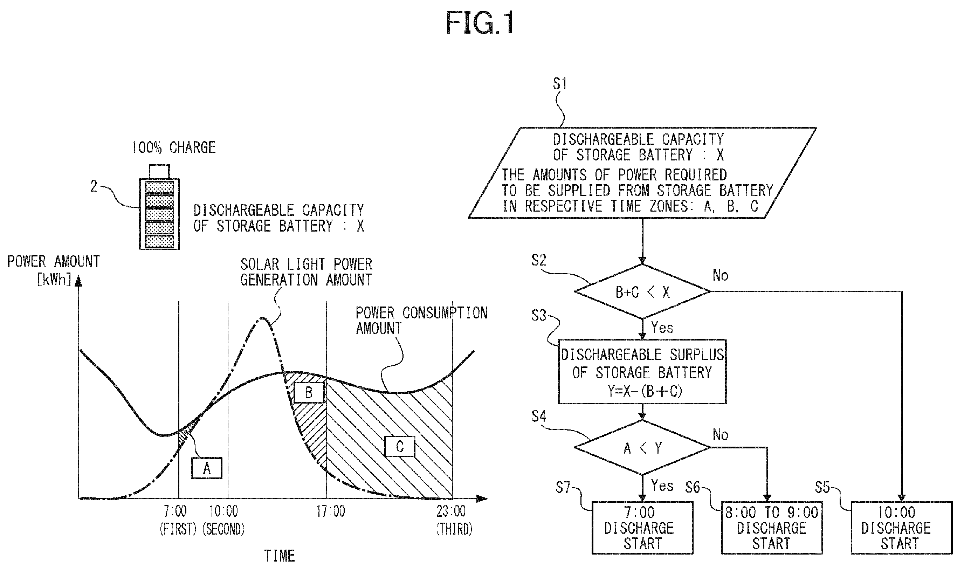

An embodiment of the present invention will be described below with reference to the drawings. FIG. 1 is an explanatory diagram illustrating a processing flow of a discharge start time determination system for a storage battery 2 serving as an electricity storage device according to the present embodiment

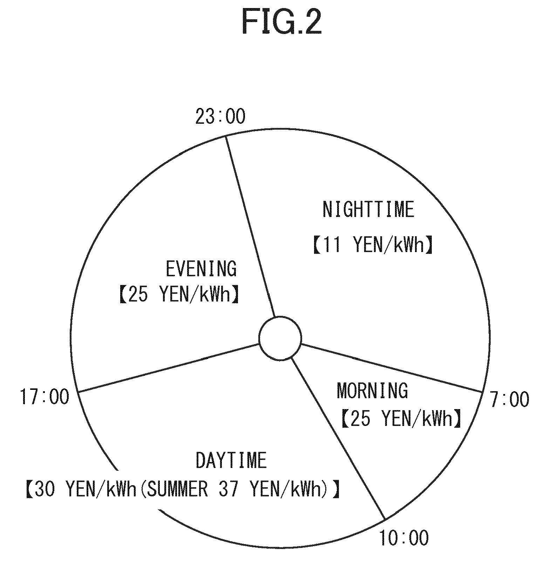

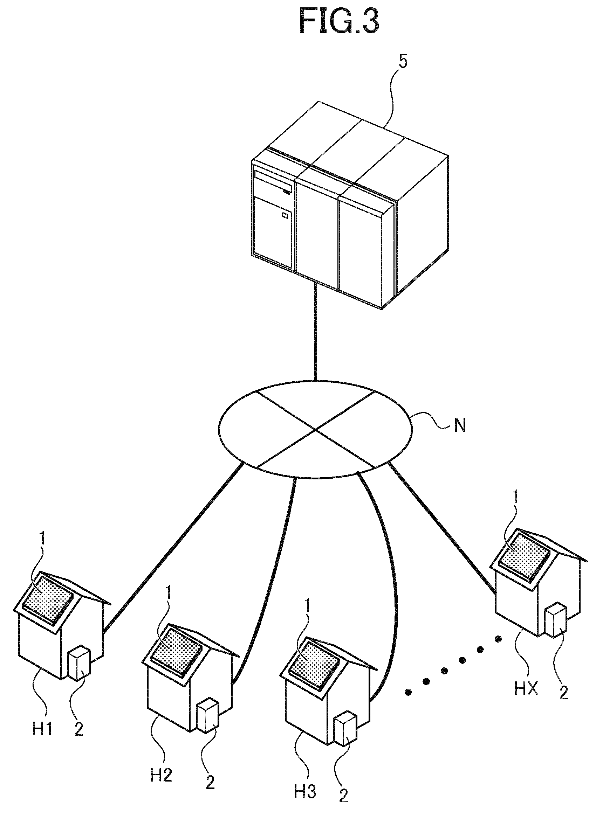

In addition, FIG. 2 is an explanatory diagram illustrating an example of a fee structure in which three or more different power prices are set. The discharge start time determination system is applied on the assumption that a fee structure includes three or more different power prices. Furthermore, FIG. 3 is an explanatory diagram schematically illustrating a configuration of an entire system to which the discharge start time determination system is connected.

First, the entire configuration of the system will be described with reference to FIG. 3. Homes H1, ... , HX, as buildings controlled by the system, are connected to a system power network serving as a power network for receiving power supply from a system power such as a power plant of an electric power company and a cogeneration facility located for each region.

In addition, these homes H1, ... each include a solar cell panel 1 serving as a solar power generator and the storage battery 2 serving as an electricity storage device that temporarily stores electric power. Furthermore, these homes H1, ... are connected to an external communication network N such as the Internet. Then, transmission and reception are performed with an external management server 5, which is also connected to the communication network N. For example, data such as a measured value and a calculation processing result, and control signals are transmitted and received between the homes and the external management server 5.

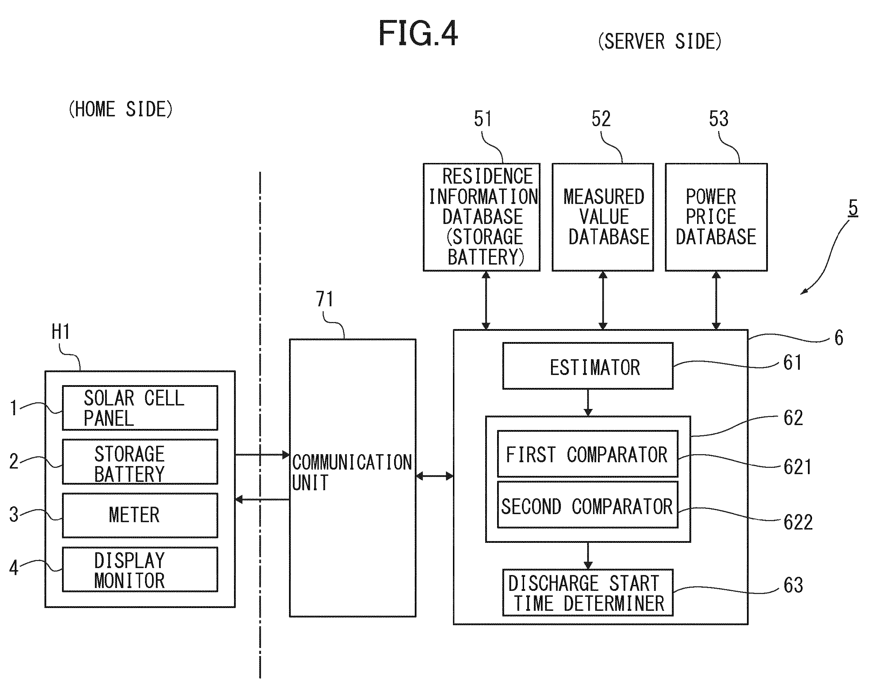

FIG. 4 is a block diagram illustrating details of the entire system schematically illustrated in FIG. 3. This entire system includes home-side components arranged in the home H1, and server-side components arranged in the management server 5.

The home H1 to be processed mainly includes the solar cell panel 1, the storage battery 2, a meter 3 that measures a power generation amount of the solar cell panel 1 and a power consumption amount of the home H1, and a display monitor 4 serving as a display device.

The solar cell panel 1 installed on the home H1 is a device that generates power by directly converting solar light as solar energy into electric power using a solar cell.

The solar cell panel 1 is a device that can supply power only in a solar light-receivable time zone. In addition, direct-current power generated by the solar cell panel 1 is generally converted into alternating-current power by a power conditioner (not illustrated) to be used. The specification of the solar cell panel 1 installed on the home H1, such as power generation capacity, is stored in a residence information database 51 on the management server 5 side, which will be described later.

On the other hand, similarly to the solar cell panel 1, the storage battery 2 is also connected to the power conditioner, so that charging control and discharging control are performed. For example, the storage battery 2 is charged using power with a low power price such as nighttime power supplied from the system power network. The specification of the storage battery 2, such as power storage capacity and rated power output, is also stored in the residence information database 51 on the management server 5 side.

In addition, various power load devices to which power is supplied through a power distribution board are installed in the home H1. The power load devices that operate using power include, for example, an air conditioner, an illumination device such as an illumination stand and a ceiling light, and a home electrical appliance such as a refrigerator and a television.

In addition, when an electric vehicle or a plug-in hybrid car is charged for traveling, it functions as a power load device. In addition, similarly to the storage battery 2, when the electric vehicle or the plug-in hybrid car is discharged for the power load devices in the home H1, it functions as an electricity storage device.

The meter 3 measures the amount of power actually generated by the solar cell panel 1 installed on the home H1. In addition, the meter 3 also measures the amount of power consumed by the power load devices installed in the home H1. The amount of consumed power can be collectively measured via the power distribution board, or can be measured for each power load device.

The measurement by the meter 3 can be performed at an arbitrary interval. For example, the meter 3 may perform measurement on a second basis, on a minute basis, or on an hourly basis. In addition, a measured value(s) measured by the meter 3 is(are) stored in a measured value database 52 on the management server 5 side, which will be described later, every time the measurement is performed, or every time measured values are collected in an arbitrary time period, such as on an hourly basis or on a daily basis.

On the display monitor 4, measured values measured by the meter 3, a determination result obtained by a discharge start time determiner 63 on the management server 5 side, which will be described later, and the like are displayed. The display monitor 4 may be a dedicated terminal monitor or a screen of a general-purpose device such as a personal computer.

In addition, on the side of the management server 5 connected to the home H1 via the external communication network N, a communication unit 71 serving as a communication tool, a controller 6 that performs various types control, and various databases (51, 52, and 53) serving as a memory are mainly provided.

The communication unit 71 has a function of transferring, to the controller 6 of the management server 5, the specifications of various devices, measured values, processing requests, and the like that are transmitted from the home H1, and also transferring, to the home H1, data stored in the various databases (51, 52, and 53), a result of calculation processing performed by the controller 6, an update program, and the like.

In addition, data is written into or read from the memory via the controller 6. Such a memory includes various databases such as the residence information database 51, the measured value database 52, and the power price database 53.

For example, the following types of information are stored in the residence information database 51: respective residence codes (identification numbers) of the homes H1, ..., HX, and addresses, built years, thermal insulation performances, room layouts, electrical wirings, used members, the specifications (power generation capacity (output)) of the solar cell panels 1, and the specifications (power storage capacity, rated power output) of the storage batteries 2, which are associated with the residence codes.

In addition, data of measured values measured by the home H1, ... , HX, and received by the management server 5 via the communication unit 71 are stored in the measured value database 52. These measured values are stored in the measured value database 52 in association with the residence codes. It is therefore possible to identify, from among the home H1, ... , HX, a home that has measured a corresponding result.

Furthermore, while data transmitted from the home H1 can be directly stored into the measured value database 52, a calculation processing result such as an integration result obtained by the controller 6 can also be stored therein.

On the other hand, information related to a power price (purchase price for residents) changing depending on hours of a day, which is set by an electric power company supplying system power, is stored in the power price database 53 serving as a power price memory.

The application of the discharge start time determination system according to the present embodiment is premised on that there is made a contract of a fee structure in which three or more different power prices are set in one day.

For example, in the fee structure illustrated in FIG. 2, three types of power prices are set: a morning mid-price zone starting from 7:00 (first time) and ending before 10:00, a daytime high price zone starting from 10:00 (second time) and ending before 17:00, an evening mid-price zone starting from 17:00 and ending before 23:00, and a nighttime low price zone starting from 23:00 (third time) and ending before 7:00 (first time) of the following day.

In other words, times at which the power price is changed and power prices of the respective time zones are stored in the power price database 53. In addition, a purchase price (electric power selling price for residents) that an electric power company or the like pays to purchase the power generated by the solar cell panel 1 is also stored in the power price database 53.

In addition, the controller 6 includes an estimator 61, a comparator 62 including a first comparator 621 and a second comparator 622, and the discharge start time determiner 63. The components included in the controller 6 are main components of the discharge start time determination system for the storage battery 2 according to the present embodiment.

The estimator 61 estimates a power generation amount of the solar cell panel 1 and a power consumption amount of the home H1 of a day for which an optimum discharge start time of the storage battery 2 is to be determined. For example, the estimator 61 can estimate, on a previous day of the target day, a power generation amount and a power consumption amount of the following day (target day). In addition, when determining by the previous day a discharge start time to be applied to an arbitrary time period (one week, ten days, one month, etc.), the estimator 61 can also estimate an average value corresponding to the arbitrary time period.

The estimator 61 performs estimation based on measured values measured by the meter 3 and accumulated in the measured value database 52. In addition, details of the estimation method will be described later.

In addition, the comparator 62 compares a power generation amount and a power consumption amount that have been estimated by the estimator 61, with a dischargeable capacity X of the storage battery 2. FIG. 1 is a diagram for illustrating the details of the comparator 62.

The dischargeable capacity X of the storage battery 2 can be calculated based on values stored in the residence information database 51. Generally, in order to extend the life of the storage battery 2, not all the power storage capacity is discharged. Thus, the dischargeable capacity X illustrated in FIG. 1 is a capacity set assuming that 100% can be discharged.

In addition, the curves of a solar light power generation amount and a power consumption amount illustrated in a graph on the left side in FIG. 1 represent power generation amounts and power consumption amounts that have been estimated by the estimator 61. First, the amounts of power required to be supplied from the system power network or the storage battery 2 in the respective time zones, which are indicated by areas of A, B, and C, are calculated.

In other words, when a power consumption amount exceeds a power generation amount, power is required to be supplied from the system power network or the storage battery 2. The amount of the required power corresponds to a necessary amount (A, B, or C) in a corresponding time zone. The necessary amount (A, B, or C) can be calculated by subtracting a solar light power generation amount from a power consumption amount, and integrating the subtracted values in the corresponding time zone. In addition, when solar light power generation amounts are equal to or larger than power consumption amounts at all times in a time zone, a necessary amount in the time zone becomes 0.

In this graph, a morning necessary amount A represents the amount of power required to be supplied in a morning time zone (mid-price zone) starting from 7:00 and ending before 10:00, in which a power price is higher than that in the nighttime. In addition, a daytime necessary amount B represents the amount of power required to be supplied in a daytime time zone (high price zone) starting from 10:00 and ending before 17:00, in which a power price is the highest in a day.

Furthermore, an evening necessary amount C represents the amount of power required to be supplied in an evening time zone (mid-price zone) starting from 17:00 and ending before 23:00, in which a power price is lower than that in the daytime. The calculation performed so far corresponds to step S1 in the flowchart illustrated on the right side in FIG 1.

Next, the first comparator 621 compares the daytime and evening necessary amounts (B and C) with the dischargeable capacity X (step S2). More specifically, the first comparator 621 compares the sum of the daytime necessary amount B in the daytime time zone with the highest power price and the evening necessary amount C in the evening time zone following the daytime time zone, as a necessary amount (B + C) at a high price time, with the dischargeable capacity X.

If it is determined based on the comparison result that only the necessary amount (B + C) at the high price time can be supplied by the dischargeable capacity X (B + C ≥ X), 10:00, at which the mid-price zone changes to the high price zone, is determined as a discharge start time (step S5).

In contrast, if it is determined that the dischargeable capacity X exceeds the necessary amount (B + C) at the high price time (B + C < X), the second comparator 622 calculates a surplus discharge amount Y by subtracting the necessary amount (B + C) at the high price time from the dischargeable capacity X (step S3).

Then in step S4, the morning necessary amount A in the morning time zone as a necessary amount at a mid-price time is compared with the surplus discharge amount Y. If it is determined based on the comparison result that only the necessary amount (A) at the mid-price time can be supplied by the surplus discharge amount Y (A ≥ Y), any time in the mid-price zone starting from 7:00 and ending before 10:00 is determined as a discharge start time (step S6). In step S6, 8:00 to 9:00 is determined as a discharge start time.

In contrast, if it is determined that the surplus discharge amount Y exceeds the necessary amount (A) at the mid-price time (A < Y), 7:00, at which the low price zone changes to the mid-price zone, is determined as a discharge start time (step S7).

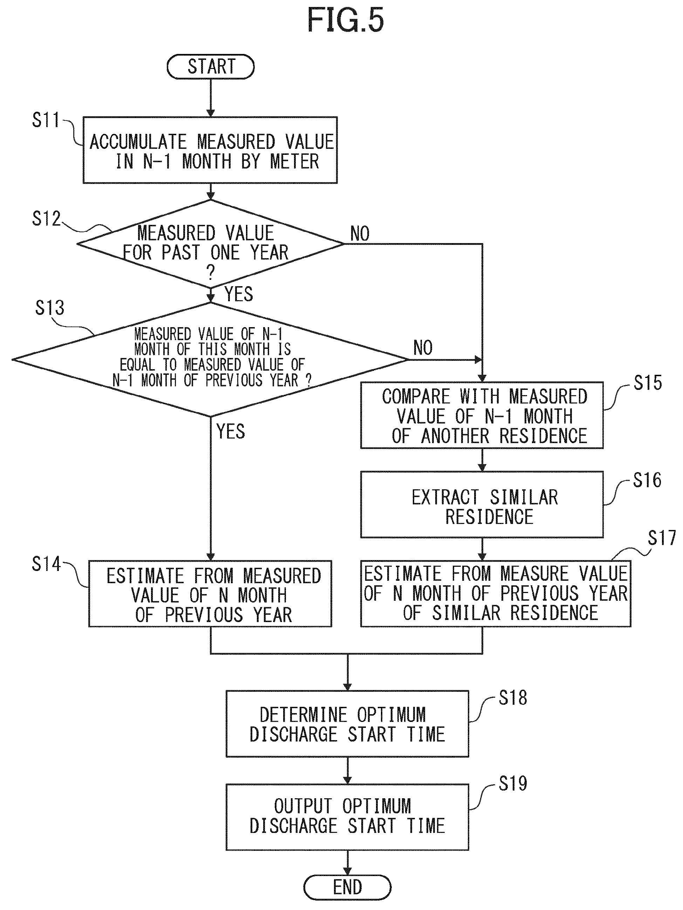

Next, a processing flow of the entire system including the discharge start time determination system for the storage battery 2 according to the present embodiment will be described with reference to FIG. 5.

First, in step S11, the meter 3 of the home H1 calculates a power generation amount of the solar cell panel 1, and a power consumption amount of the home H1, which corresponds to power consumption amounts of all the power load devices installed in the home H1.

In this step, in order to perform estimation for determining an optimum discharge start time of the storage battery 2 in an N month (the present month), measured values are accumulated at least for a time period (e.g., one month) in which similarly comparison is to be made. In other words, in step S11, measured values measured by the home H1 in an N-1 month (the previous month) are stored into the measured value database 52.

In addition, if 13 months or more have passed since the home H1 had been built, the estimation of the N month (the present month) can be performed using measured values actually measured by the home H1 a year ago. Thus, in step S12, it is determined whether measured values of the home H1 that correspond to the past one year are accumulated.

If measured values of the N-1 month of the previous year are accumulated, the measured values are read from the measured value database 52, and measured values of the previous month (N-1 month) are compared with the measured values of the N-1 month of the previous year (step S13).

If it is determined based on the comparison result that the measured values of the previous month (N-1 month) and the measured values of the N-1 month of the previous year are within a range in which they can be regarded as equal or similar to each other, measured values of the N month of the previous year are directly used as estimated values of a power generation amount and a power consumption amount of the present month (N month) of this year (step S14).

In contrast, if the home H1 is a newly-built home, or if it is soon after the meter 3 has been installed, measured values corresponding to the past one year are not accumulated. Thus, in step S 15, comparison with another residence is made.

More specifically, as illustrated in FIG. 3, many homes H2, ... , HX are connected to the management server 5, besides the home H1 to be processed. In addition, the respective meters 3, ... are installed in these homes H2, ... , HX. Thus, measured values obtained by these meters 3 are accumulated in the measured value database 52.

Thus, if a home measures measured values equal or similar to the measured values of the previous month (N-1 month) of the home H1 to be processed, among measured values measured by the homes H2, ... , HX in the previous month (N-1 month), the home is extracted as a similar residence (step S16).

When a similar residence is extracted, similar homes are searched for in the order of the daytime necessary amount B, the evening necessary amount C, and the morning necessary amount A, and the closest home is extracted as a similar residence. For example, when the home H2 is extracted as a similar residence, if measured values of the home H2 that correspond to the past one year are accumulated, measured values of the N month of the previous year of the home H2 are used as estimated values of a power generation amount and a power consumption amount of the present month (N month) of this year of the home H1 (step S 17).

The above-described processes from steps S15 to S17 are performed also when it is determined in step S13 that the measured values of the previous month (N-1 month) and the measured values of the N-1 month of the previous year cannot be regarded as equal or similar to each other, based on the comparison therebetween.

The processes performed in the above steps correspond to the estimation performed by the estimator 61. Then, an optimum discharge start time is determined using the estimated power generation amount and power consumption amount in the N month of this year of the home H1 (step S18).

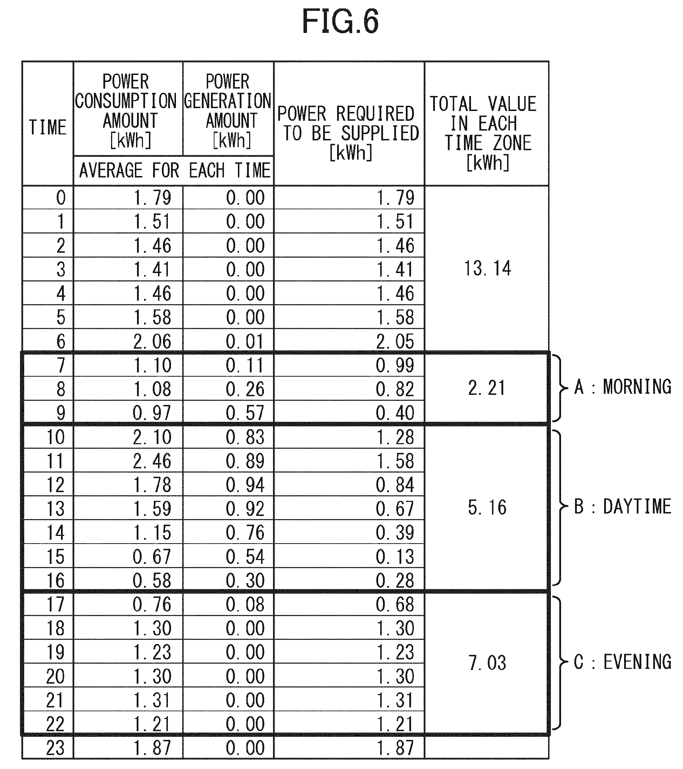

FIG. 6 illustrates examples of estimated values of power generation amounts of the solar cell panel 1 and power consumption amounts that have been estimated by the estimator 61. More specifically, in the table illustrated in FIG. 6, on the second column from the left, an average value of power consumption amounts in the N month (the present month) of this year of the home H1 is shown for each hour as an estimated value. In addition, on the next column, an average value of power generation amounts of the solar cell panel 1 in the N month (the present month) is shown for each hour as an estimated value.

Here, the processing flow of the determination of an optimum discharge start time has already been described with reference to FIG. 1. More specifically, a power generation amount is subtracted from a power consumption amount for each hour to calculate the amount of power required to be supplied (necessary amount). In addition, in the table illustrated in FIG. 6, there is no hour in which a power generation amount exceeds a power consumption amount, unlike FIG. 1.

Then, the calculated necessary amounts of the respective hours are integrated for each time zone to obtain the morning necessary amount A (= 2.21 kWh), the daytime necessary amount B (= 5.16 kWh), and the evening necessary amount C (= 7.03 kWh) (step S1 in FIG. 1).

Subsequently, the comparisons by the first comparator 621 and the second comparator 622 are performed as described above, and the most appropriate discharge start time is determined (steps S2 to S7 in FIG. 1). Based on the values listed in the table illustrated in FIG. 6, the determination is made as follows: the daytime necessary amount B + the evening necessary amount C = 5.16 kWh + 7.03 kWh ≥ 5.05 kWh when the dischargeable capacity X is 5.05 kWh, and a discharge start time is determined to be 10:00 (refer to steps S2 and S5).

The determination result calculated in this manner is output as an optimum discharge start time, as illustrated in step S19 in FIG. 5. In other words, as illustrated in FIG. 4, the determination result obtained by the discharge start time determiner 63 is transmitted from the controller 6 to the display monitor 4 of the home H1 via the communication unit 71 to be displayed thereon.

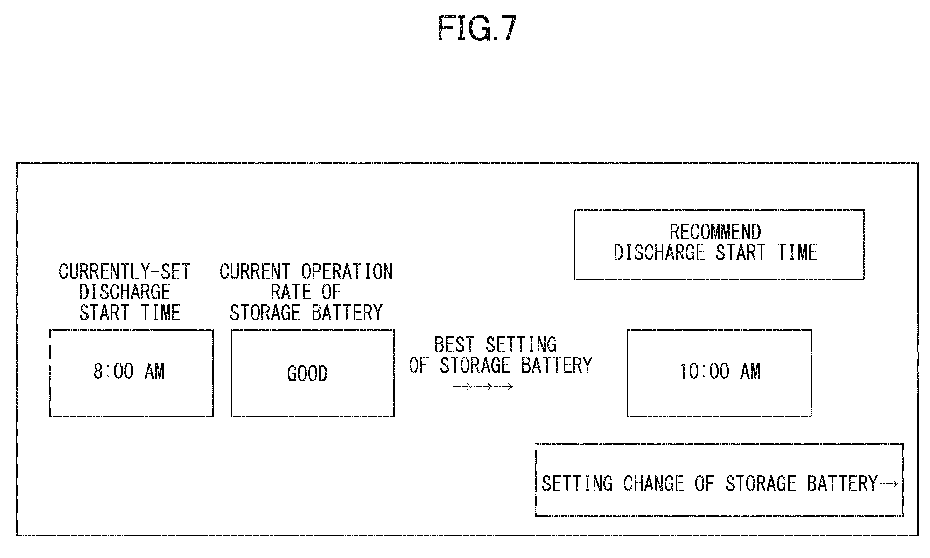

FIG. 7 is a diagram illustrating an example of a display result obtained by the display monitor 4. In this example, a currently-set discharge start time (8:00 am) of the storage battery 2 and the state (good) of the storage battery 2 are displayed together with "10:00 am" as a discharge start time for achieving the lowest electric power charge.

In addition, if a resident who sees the display on the display monitor 4 desires to make an electric power charge as low as possible, the resident can change a discharge start time setting of the storage battery 2 to 10:00 am.

Next, the mechanism of the discharge start time determination system for the storage battery 2 according to the present embodiment will be described.

The discharge start time determination system for the storage battery 2 according to the present embodiment that has the above configurations compares the necessary amount (B + C) at the high price time in a time zone with a high power price, which has been calculated by subtraction processing, with the dischargeable capacity X of the storage battery 2, and brings a discharge start time forward if the dischargeable capacity X has a surplus.

Thus, effective utilization of fully utilizing the dischargeable capacity X of the storage battery 2 can be achieved with less calculation load, i.e., subtraction. Furthermore, in addition to the above comparison, the necessary amount (A) at the mid-price time in a time zone with a mid-power price, which has been calculated by subtraction processing, is compared with the surplus discharge amount Y, so that a more economical discharge start time can be proposed.

In other words, by charging the storage battery 2 in the time zone with a low power price (low price zone), and discharging the charged power for use in the time zone with a high power price (high price zone) and in the time zone with a mid-power price (mid-price zone), an electric power charge of the home H1 can be reduced.

For example, if a morning power consumption amount on weekdays increases or a daytime power consumption amount on holidays increases due to a change in lifestyle of a resident, an optimum discharge start time may vary. Moreover, if a season, a family structure, or a fee structure of power prices changes, an optimum discharge start time may accordingly vary. Thus, by reviewing an optimum discharge start time occasionally or periodically, an electric power charge of the home H1 can be reduced. In addition, the determination result obtained by the discharge start time determination system for the storage battery 2 according to the present embodiment provides a resident with a preferred decision criterion.

In addition, by performing estimation based on measured values actually accumulated by the meter 3 in the home H1, estimation can be performed considering equipped devices and thermal insulation performance of the home H1, a lifestyle of a resident, a season, a family structure, and the like.

Furthermore, even at a stage where measured values of the home H1 to be processed are not sufficiently accumulated, by performing estimation based on equal or similar measured values of other homes H2, ... , HX, estimation accuracy can be enhanced.

In addition, by outputting a determination result of a discharge start time to the display monitor 4 such as a terminal monitor and a screen of a personal computer, or to a printing device such as a printer and a facsimile, the user can be easily guided to more appropriate discharging or optimum discharging.

The embodiment of the present invention has been described above in detail with reference to the drawings. Specific configurations, however, are not limited to those described in this embodiment, and a design change without departing from the gist of the present invention is included in the present invention.

For example, in the above embodiment, the description has been given taking an example of a fee structure in which three different power prices exist in one day. The fee structure, however, is not limited to this. The power prices and the times at which the power price is changed that have been described in the above embodiment are only examples. The time at which a power price is changed and the number of time zones having different prices vary depending on the management policy of a company supplying system power such as an electric power company, and a policy conducted by the company at that time.

In addition, in the above embodiment, the description has been given of a case in which a determination result of a discharge start time that has been transmitted via the communication unit 71 of the management server 5 is displayed on the display monitor 4. This, however, is not a limiting case. The determination result can also be displayed on a screen of a mobile phone or a personal computer via an electronic mail. In addition, a resident can recognize a determination result by viewing a predetermined web page.

Furthermore, in the above embodiment, the description has been given of the estimator 61 that performs estimation based on measured values measured by the meter 3 of the home H1. This, however, is not a limiting case. The average value and the like that are obtained from existing statistical data can also be used as estimated values.

In addition, in the above embodiment, the description has been given of a case in which the determination result obtained by the discharge start time determiner 63 is merely displayed on the display monitor 4, and a setting of the storage battery 2 is changed by a resident. This, however, is not a limiting case. For example, by outputting a determination result of a discharge start time to a control device of the storage battery 2, optimum discharge control can be automatically performed.

In addition, in the above embodiment, the description has been given of the discharge start time determination system for the storage battery 2. This, however, is not a limiting case. The present invention may be applied to a discharge start time determination method for an electricity storage device that partially uses or never uses a calculation device or the like.

### [CROSS-REFERENCE TO RELATED APPLICATION]

The present application claims priority based on Japanese Patent Application No. 2013-185387, filed on September 6, 2013, the disclosure of which is hereby incorporated by reference in its entirety.

## Claims

1. A discharge start time determination system for an electricity storage device in a building including a solar power generator and an electricity storage device, the discharge start time determination system comprising:
an estimator that estimates a power generation amount of the solar power generator and a power consumption amount of the building;
a power price memory that stores times at which price zones having different power prices are changed, the price zones including a mid-price zone starting from a first time and ending before a second time, a high price zone starting from the second time and ending before a third time, and a low price zone starting from the third time and ending before the first time of a following day;
a first comparator that compares a necessary amount at a high price time that is obtained by subtracting the power generation amount from the power consumption amount in the high price zone, with a dischargeable capacity of the electricity storage device; and
a discharge start time determiner that, when the necessary amount at the high price time is estimated by the first comparator to be the dischargeable capacity or more, sets the second time as a discharge start time, and that, when the necessary amount at the high price time is estimated to be less than the dischargeable capacity, sets any time that is equal to or later than the first time and earlier than the second time as the discharge start time.

2. The discharge start time determination system for an electricity storage device according to claim 1, further comprising:
a second comparator that, when the necessary amount at the high price time is estimated by the first comparator to be less than the dischargeable capacity, compares a surplus discharge amount obtained by subtracting the necessary amount at the high price time from the dischargeable capacity, with a necessary amount at a mid-price time that is obtained by subtracting the power generation amount from the power consumption amount in the mid-price zone,
wherein the discharge start time determiner sets, when the necessary amount at the mid-price time is estimated by the second comparator to be less than the surplus discharge amount, the first time as the discharge start time, and sets, when the necessary amount at the mid-price time is estimated to be the surplus discharge amount or more, any time that is later than the first time and earlier than the second time as the discharge start time.

3. The discharge start time determination system for an electricity storage device according to claim 1 or 2, further comprising:
a meter that measures the power generation amount of the solar power generator and the power consumption amount of the building,
wherein the estimator performs estimation based on a measured value obtained by the meter.

4. The discharge start time determination system for an electricity storage device according to claim 3,
wherein the estimator performs estimation based on a measured value in another building in which a measured value equal or similar to a measured value obtained by the meter in a period in which comparison is to be made.

5. The discharge start time determination system for an electricity storage device according to any one of claims 1 to 4,
wherein a determination result obtained by the discharge start time determiner is output to a display device or a printing device.

6. The discharge start time determination system for an electricity storage device according to any one of claims 1 to 5,
wherein a determination result obtained by the discharge start time determiner is output to a control device for controlling the electricity storage device.

7. A discharge start time determination method for an electricity storage device in a building including a solar power generator and an electricity storage device, when a mid-price zone starting from a first time and ending before a second time, a high price zone starting from the second time and ending before a third time, and a low price zone starting from the third time and ending before the first time of a following day are different in power price, the discharge start time determination method comprising:
an estimation step of estimating a power generation amount of the solar power generator and a power consumption amount of the building;
a first comparison step of comparing a necessary amount at a high price time that is obtained by subtracting the power generation amount from the power consumption amount in the high price zone, with a dischargeable capacity of the electricity storage device; and
a discharge start time determination step of, when the necessary amount at the high price time is estimated in the first comparison step to be the dischargeable capacity or more, setting the second time as a discharge start time, and of, when the necessary amount at the high price time is estimated to be less than the dischargeable capacity, setting any time that is equal to or later than the first time and earlier than the second time as a discharge start time.
